**Europäisches Patentamt**

**European Patent Office**

**Office européen des brevets**

(19)

(11) Veröffentlichungsnummer: **0 075 254**
**B1**

# (12) EUROPÄISCHE PATENTSCHRIFT

(45) Veröffentlichungstag der Patentschrift:
**17.04.85**

(51) Int. Cl.⁴: **G 01 R 17/06**, G 01 G 3/147

(21) Anmeldenummer: **82108471.2**

(22) Anmeldetag: **14.09.82**

(54) Verfahren zur Erzeugung einer Zeitteilerimpulsfolge für eine Nachlaufsteuerung.

(30) Priorität: **18.09.81 DE 3137244**

(43) Veröffentlichungstag der Anmeldung:
**30.03.83 Patentblatt 83/13**

(45) Bekanntmachung des Hinweises auf die Patenterteilung:
**17.04.85 Patentblatt 85/16**

(84) Benannte Vertragsstaaten:
**AT BE DE FR GB IT LU NL**

(56) Entgegenhaltungen:
**DE - A - 2 938 116**
**DE - B - 2 260 439**
**DE - B - 2 841 830**

(73) Patentinhaber: **Siemens Aktiengesellschaft, Berlin und München Wittelsbacherplatz 2, D-8000 München 2 (DE)**

(72) Erfinder: **Förnsel, Helmut, Ing. grad., Zietenstrasse 12, D-7500 Karlsruhe (DE)**
Erfinder: **Schröder, Heinrich, Dipl.-Ing., Max-Beckmann-Strasse 26, D-7500 Karlsruhe 41 (DE)**

## Beschreibung

Die Erfindung bezieht sich auf ein Verfahren zur Erzeugung einer Zeitteilerimpulsfolge für eine Nachlaufsteuerung, bei dem ein Zähler in gleichen Zeitabständen mit einem jeweils vorliegenden, digital gespeicherten Meßwert aufgeladen und durch eine Taktimpulsfolge entladen wird, wobei das Verhältnis der gleichen Zeitabstände zur meßwertproportionalen Entladezeit das Tastverhältnis der Zeitteilerimpulse bestimmt.

Ein derartiges Verfahren ist aus der DE-PS 2 841 830 bekannt. Dabei werden nach Spalte 4, Zeilen 23 bis 28, zwei Zähler mit den Inhalten eines Meßwertspeichers bzw. eines Endwertspeichers geladen und zugleich von Taktimpulsen eines Taktgenerators leergezählt. Das aufeinanderfolgende Eintreten der Nullzustände der beiden Zähler bestimmt dabei das Tastverhältnis der Zeitteilerimpulse. Das bekannte Verfahren dient zur Nachlaufsteuerung eines selbsttätigen Kompensators, bei dem eine Meßspannung mit Hilfe eines durch alternierendes Ein- und Ausschalten erzeugten Mittelwertes einer Kompensationsspannung kompensiert wird. Der Mittelwert wird dabei durch das Tastverhältnis einer sogenannten Zeitteilerimpulsfolge gesteuert. Die jeweilige Differenz der Meß- und der Kompensationsspannung regelt über ein Nachlaufsystem das Tastverhältnis der Zeitteilerimpulse.

Der Erfindung lag die Aufgabe zugrunde, einen der Umwandlung des digitalen Meßwertes in eine proportionale Zeitspanne dienenden Zähler zugleich zur Bemessung der Periode der Zeitteilerimpulsfolge zu benutzen.

In einer bevorzugten Ausführungsform wird diese Aufgabe gemäß der Erfindung durch die Merkmale des Anspruchs 1 gelöst.

Eine zweite Ausführungsform der Erfindung ist dadurch gekennzeichnet, daß ein den Entladezustand des Zählers anzeigender Übertragsimpuls den Stelleingang eines Flip-Flops beaufschlagt, von dessen gegenseitig inversen Ausgängen abwechselnd die Übernahme des digital gespeicherten Meßwertes bzw. seines zur Zählerkapazität komplementären Wertes in den Zähler vermittelnde Einrichtungen angeregt werden und die gleichen Ausgänge über ein ODER-Gatter den Zählereingang für die Taktimpulse öffnen sowie einem der Ausgänge des Flip-Flops die Zeitteilerimpulsfolge entnommen wird.

Als Zähler wird zweckmäßig ein in einem Mikrocomputer integrierter Zähler verwendet.

Mit Vorteil wird auch zur Speicherung des Meßwertes und eventuell davon abgeleiteter Werte der Mikrocomputer herangezogen.

Bevorzugt ist das Verfahren bei einer elektrischen Auswägeeinrichtung einer elektromechanischen Waage zu verwenden.

Die Erfindung wird anhand von vier Figuren erläutert.

Fig. 1 stellt das Blockschaltbild eines bevorzugten Anwendungsbeispiels der Erfindung dar; in

Fig. 2 sind drei Diagramme gezeigt, welche die Erzeugung der Zeitteilerimpulse verdeutlichen;

Fig. 3 stellt das Blockschaltbild einer zweiten Anwendung der Erfindung dar; in

Fig. 4 zeigt ein Diagramm den zeitlichen Ablauf des Zählerinhaltes, der das Tastverhältnis eines Zeitteilerimpulses bestimmt.

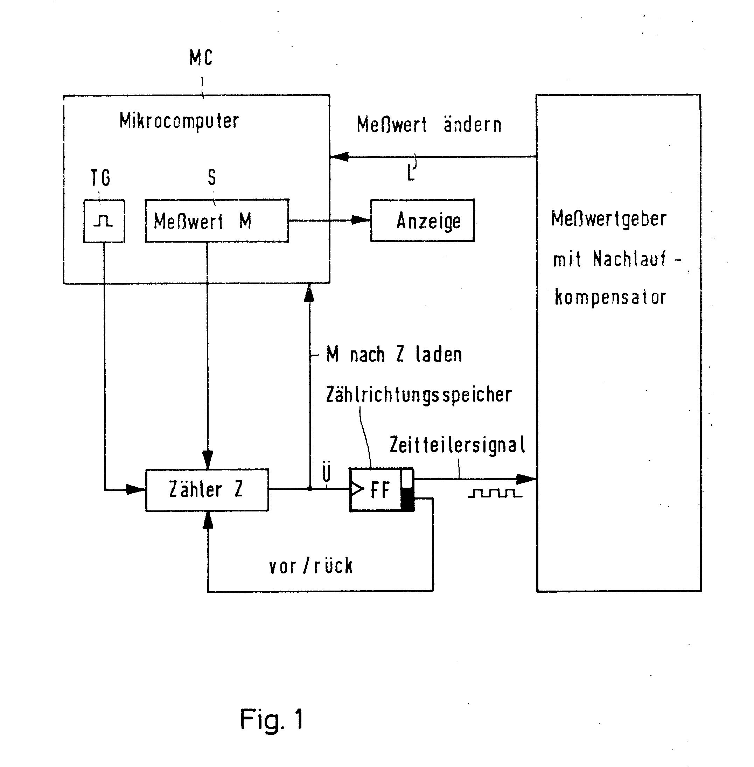

In Fig. 1 sind Biteingänge eines Vor-Rückwärtszählers Z mit Bitausgängen eines in einem Mikrocomputer MC enthaltenen Speichers S für einen digitalisierten Meßwert M verbunden. An einem Zähleingang des Zählers Z liegt der Ausgang eines ebenfalls dem Mikrocomputer MC angehörenden Taktgenerators TG. Ein Übertragsausgang des Zählers Z, der sowohl auf den voll- als auch leergezählten Zustand des Zählers anspricht, ist einerseits mit dem Setzeingang eines Flip-Flops FF und andererseits mit einer Einrichtung im Mikrocomputer MC verbunden, welche die Übernahme des Inhaltes M des Speichers S durch den Zähler Z vermittelt. Einer von zwei gegenseitig inversen Ausgängen des als Zählrichtungsspeicher dienenden Flip-Flops FF ist mit einem Steuereingang des Zählers Z verbunden, der es gestattet, den Zähler von Vorwärtszählen auf Rückwärtszählen umzuschalten. Der andere der beiden Ausgänge des Flip-Flops FF liefert eine Zeitteilerimpulsfolge an einen mit einem Nachlaufsystem ausgerüsteten selbsttätigen Meßwertkompensator. Eine Leitung L zum Übertragen des Meßwertes verbindet den Meßwertkompensator mit dem Mikrocomputer MC, der mit einer entsprechenden Einrichtung die Digitalisierung des Meßwertes vornimmt.

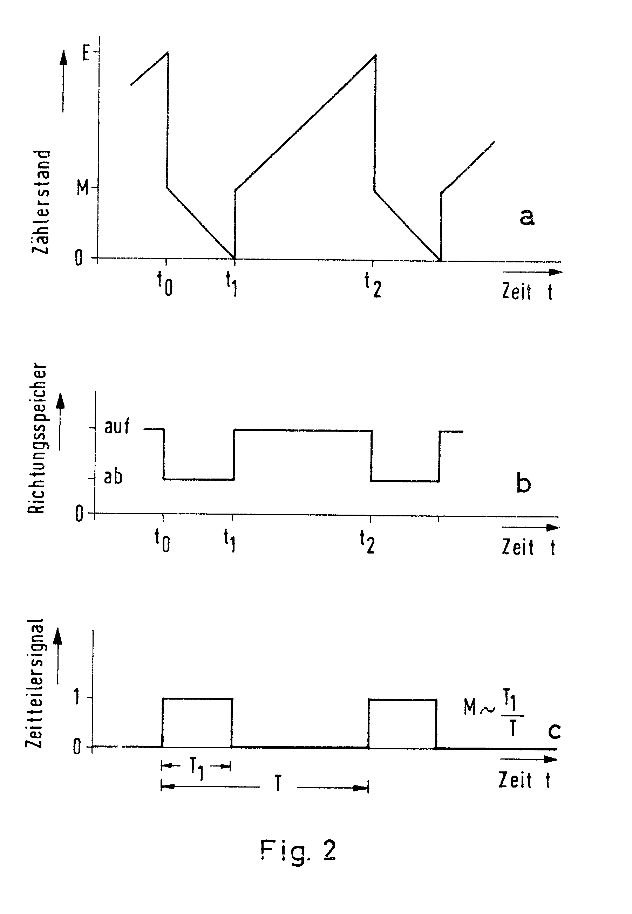

In der Fig. 2 ist im ersten Diagramm a der Zählerstand des Zählers Z gegenüber der Zeit aufgetragen. Es ist zu erkennen, wie beim Endstand E des Zählers zum Zeitpunkt $t_0$ der Zähler Z durch Übernahme des Meßwertes M aus dem Speicher S aufgeladen und dann bis zum Zeitpunkt $t_1$ von den Taktimpulsen entladen wird. Beim Zählerstand »0« wird der gleiche Meßwert M wieder aus dem Speicher S in den Zähler Z übertragen und durch Aufwärtszählen der Taktimpulse der Endstand E des Zählers erreicht. Dies ist bei einem Zeitpunkt $t_2$ der Fall. Die Zeit zwischen $t_0$ und $t_2$ ist, weil sie nur von der Kapazität des Zählers und der Frequenz der Taktimpulse bestimmt wird, konstant. Sie stellt die Periode T der Zeitteilerimpulse dar. Die Spannen zwischen der Zeit $t_0$ und $t_1$ bzw. $t_1$ und $t_2$ sind dagegen abhängig von der Größe des Meßwertes M.

Im Diagramm b ist der Verlauf der Ausgangsspannung eines Ausgangs des Flip-Flops FF dargestellt, das als Zählrichtungsspeicher dient.

Das Diagramm c zeigt den Verlauf des Zeitteilersignals mit der Periode T und dem Tastverhältnis $T_1/T$.

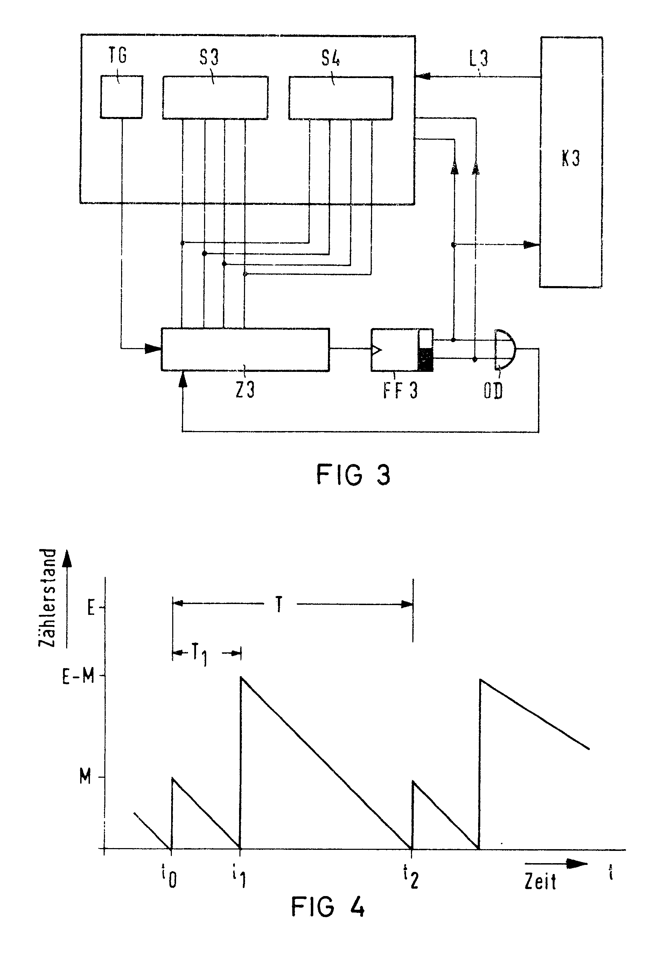

In der Fig. 3 ist ein Abwärtszähler Z3 mit Biteingängen an Speicher S3 bzw. S4 anschließbar, wobei im Speicher S3 wieder der Meßwert M und im Speicher S4 sein zum Endwert E des Zählers Z3 komplementärer Wert E–M gespeichert ist. Ein Übertragsausgang, der den Nullzustand des Zählers Z3 anzeigt, ist mit dem Setzeingang eines Flip-Flops FF3 verbunden. Die beiden gegenseitig inversen Ausgänge des Flip-Flops FF3 steuern Einrichtungen, welche die Übernahme des Inhaltes der Speicher S3 bzw. S4 durch den Zähler Z3 vermitteln. Einem Zähleingang des Zählers Z3 ist der Ausgang eines Taktgenerators TG zugeführt. Die beiden Ausgänge des Flip-Flops FF3 steuern zusätzlich über ein ODER-Gatter OD ein Zählereingangstor des Zählers Z3. Einer der Ausgänge des Flip-Flops FF3 liefert die Zeitteilerimpulsfolge an einen Kompensator K3, der seinerseits den Meßwert an den Mikrocomputer MC3 über eine Leitung L3 weitergibt.

In Fig. 4 ist der Zählerstand des Zählers Z3 in seinem zeitlichen Verlauf dargestellt. Zur Zeit $t_0$ wird der Meßwert vom Speicher S3 übernommen und anschließend durch die Taktimpulsfolge auf »0« zurückgezählt. Zum Zeitpunkt $t_1$ wird dem Zähler aus dem Speicher S4 die Differenz zwischen dem höchstmöglichen Endwert des Zählers und dem Meßwert eingegeben und anschließend bis zum Zeitpunkt $t_2$ der Zähler wieder leergezählt. Die Zeit zwischen $t_0$ und $t_2$ ist die Periode T der Zeitteilerimpulsfolge, die Zeit zwischen $t_0$ und $t_1$ ist die Zeit $T_1$, die vom Meßwert abhängig ist. Das Verhältnis $T_1/T$ stellt das Tastverhältnis der Zeitteilerimpulsfolge dar.

## Patentansprüche

1. Verfahren zur Erzeugung einer Zeitteilerimpulsfolge für eine Nachlaufsteuerung, bei dem ein Zähler (Z) in gleichen Zeitabständen (T) mit einem jeweils vorliegenden, digital gespeicherten Meßwert (M) aufgeladen und durch eine Taktimpulsfolge entladen wird, wobei das Verhältnis der gleichen Zeitabstände (T) zur meßwertproportionalen Entladezeit ($T_1$) das Tastverhältnis ($T_1/T$) der Zeitteilerimpulse bestimmt, dadurch gekennzeichnet, daß der Zähler (Z) ein Vor-Rückwärtszähler ist und Voll- und Leerzustände dieses Zählers (Z) anzeigende Übertragssignale eine die Übernahme des digital gespeicherten Meßwertes (M) in den Zähler (Z) vermittelnde Einrichtung steuern sowie den Stelleingang eines als Zählrichtungsspeicher dienenden Flip-Flops (FF) beaufschlagen, an dessen gegenseitig inversen Ausgängen ein Zählrichtungssignal zur Steuerung des Zählereingangs bzw. die Zeitteilerimpulsfolge entnommen wird.

2. Verfahren zur Erzeugung einer Zeitteilerimpulsfolge für eine Nachlaufsteuerung, bei dem ein Zähler (Z3) in gleichen Zeitabständen (T) mit einem jeweils vorliegenden, digital gespeicherten Meßwert (M) aufgeladen und durch eine Taktimpulsfolge entladen wird, wobei das Verhältnis der gleichen Zeitabstände (T) zur meßwertproportionalen Entladezeit ($T_1$) das Tastverhältnis ($T_1/T$) der Zeitteilerimpulse bestimmt, dadurch gekennzeichnet, daß ein den Entladezustand des Zählers (Z3) anzeigender Übertragsimpuls den Stelleingang eines Flip-Flops (FF3) beaufschlagt, von dessen gegenseitig inversen Ausgängen abwechselnd die Übernahme des digital gespeicherten Meßwertes (M) bzw. seines zur Kapazität des Zählers (Z3) komplementären Wertes (E–M) in den Zähler (Z3) vermittelnde Einrichtungen angeregt werden und die gleichen Ausgänge über ein ODER-Gatter (OD) den Zählereingang für die Taktimpulse öffnen sowie einem der Ausgänge des Flip-Flops (FF3) die Zeitteilerimpulsfolge entnommen wird.

3. Verfahren nach Anspruch 1 oder 2, dadurch gekennzeichnet, daß als Zähler (Z, Z3) ein in einem Mikrocomputer (MC, MC3) integrierter Zähler verwendet ist.

4. Verfahren nach Anspruch oder einem der vorhergehenden Ansprüche, dadurch gekennzeichnet, daß die Speicherung des Meßwertes (M) und eventuell davon abgeleiteter Werte in einem Mikrocomputer (MC, MC3) erfolgt.

5. Verfahren nach Anspruch 1 oder einem der vorhergehenden Ansprüche, gekennzeichnet durch seine Verwendung bei einer elektronischen Auswägeeinrichtung.

## Claims

1. A method of producing a time divider pulse sequence for a follower control device, wherein at regular time intervals (T) a counter (Z) is loaded with a respectively present, digitally-stored measured value (M) and unloaded by a clock pulse sequence, where the ratio of the regular time intervals (T) to the unloading time ($T_1$) which is proportional to the measured value, determines the keying ratio ($T_1/T$) of the time divider pulses, characterised in that the counter (Z) is a count-up/count-down counter and transfer signals which indicate full and empty states of the counter (Z), control a device which introduces the transmission of the digitally stored measured value (M) into the counter (Z), and control the setting input of a flip-flop (FF) which serves as a store for the counting direction and at whose mutually inverse outputs a counting direction signal is tapped for the control of the counter input or the time divider pulse sequence, as the case may be.

2. A method of producing a time divider pulse sequence for a follower control device, wherein at regulat time intervals (T) a counter (Z3) is loaded with a respectively present, digitally stored measured value (M) and unloaded by a clock pulse sequence, where the ratio of the regular time intervals (T) to the unloading time ($T_1$) which is proportional to the measured value, determines the keying ratio ($T_1/T$) of the time divider pulses, characterised in that a transfer pulse, which indicates the unloading state of the counter (Z3), controls the setting input of a flip-flop (FF3), whose mutually inverse outputs stimulate devices which alternately introduce the transmission of the digitally stored measured value (M) or its value (E–M), which is complementary to the capacity of the counter (Z3), and the same outputs open the counter input for the clock pulses by means of an OR-gate (OD), and the time divider pulse sequence is tapped from one of the outputs of the flip-flop (FF3).

3. A method as claimed in Claim 1 or 2, characterised in that the counter (Z, Z3) is integrated in a microcomputer (MC, MC3).

4. A method as claimed in Claim 1 or one of the preceding Claims, characterised in that the storage of the measured value (M) and values, which are possibly derived therefrom, takes place in a microcomputer (MC, MC3).

5. A method as claimed in Claim 1 or one of the preceding Claims, characterised by its use in an electronic weighing device.

## Revendications

1. Procédé pour produire un train d'impulsions de division de temps pour un asservissement de poursuite, selon lequel un compteur (Z) est chargé à intervalles de temps (T) égaux d'une valeur mesurée (M) présente à chaque fois et mémorisée en numérique, et est déchargé par un train d'impulsions d'horloge, et où le rapport des intervalles de temps (T) égaux au temps de décharge ($T_1$) proprotionnel à la valeur mesurée, détermine le rapport ($T_1/T$) durée d'impulsion/ durée de cycle des impulsions de division de temps, caractérisé en ce que le compteur (Z) est un compteur/décompteur et que des signaux de transfert, indiquant les états plein et vide de ce compteur (Z) commandent un dispositif déclenchant la reprise dans le compteur (Z) de la valeur mesurée (M) mémorisée en numérique et agissent sur l'entrée de mise à 1 d'une bascule (FF) servant de mémoire de sens de comptage, aux sorties mutuellement inversées de laquelle sont prélevés un signal de sens de comptage pour commander l'entrée du compteur, de même que le train d'impulsions de division de temps.

2. Procédé pour produire un train d'impulsions de division de temps pour un asservissement de poursuite, selon lequel un compteur (Z3) est chargé à intervalles de temps (T) égaux d'une valeur mesurée (M) présente à chaque fois et mémorisée en numérique, et est déchargé par un train d'impulsions d'horloge, et où le rapport des intervalles de temps (T) égaux au temps de décharge ($T_1$) proportionnel à la valeur mesurée, détermine le rapport ($T_1/T$) durée d'impulsion/ durée de cycle des impulsions de division de temps, caractérisé en ce qu'une impulsion de transfert, indiquant l'état de décharge ou de vidage du compteur (Z3), agit sur l'entrée de mise à 1 d'une bascule (FF3) dont les sorties mutuellement inversées excitent alternativement des dispositifs déclenchant la reprise de la valeur mesurée (M) mémorisée en numérique dans le compteur (Z3) ou la reprise dans le compteur de la valeur (E−M) complémentaire à la capacité du compteur (Z3), et que les mêmes sorties, à travers une porte OU (OD), ouvrent l'entrée du compteur pour les impulsions d'horloge, avec prélèvement sur une des sorties de la bascule (FF3) du train d'impulsions de division de temps.

3. Procédé selon la revendication 1 ou 2, caractérisé en ce que le compteur (Z, Z3) utilisé est un compteur intégré dans un micro-ordinateur (MC, MC3).

4. Procédé selon la revendication 1 ou une des revendications précédentes, caractérisé en ce que la valeur mesurée (M) et des valeurs qui en sont éventuellement dérivées sont mémorisées dans un micro-ordinateur (MC, MC3).

5. Procédé selon la revendication 1 ou une des revendications précédentes, caractérisé par son utilisation sur un dispositif de pesée électronique.

MC

Mikrocomputer

Meßwert ändern

TG   S

⊓

Meßwert M → Anzeige

Meßwertgeber mit Nachlauf-kompensator

M nach Z laden

Zählrichtungsspeicher

Zeitteilersignal

Ü

Zähler Z  > FF

vor / rück

Fig. 1

$E$

Zählerstand

$M$

0

$t_0$　$t_1$　$t_2$　Zeit $t$

a

Richtungsspeicher

auf

ab

0

$t_0$　$t_1$　$t_2$　Zeit $t$

b

Zeitteilersignal

1

0

$T_1$　$T$　Zeit $t$

$M \sim \dfrac{T_1}{T}$

c

Fig. 2

7

FIG 3

FIG 4